# EUROPEAN PATENT APPLICATION

(11) **EP 1 696 706 A1**
(43) Date of publication of application: **30.08.2006**
(21) Application number: 04820324.4
(22) Date of filing: 06.12.2004
(51) Int. Cl.: H05B 33/04, H05B 33/10, H05B 33/14

(54) **SURFACE LUMINANCE AND MANUFACTURING METHOD THEREOF**

(30) Priority: 09.12.2003 JP 2003410498
(71) Applicant: Nippon Sheet Glass Co.,Ltd., Tokyo 105-8552 (JP)
(72) Inventor: YANO, Yuichi, Nippon Sheet Glass Company Limited, Tokyo 105-8552 (JP)
(74) Representative: Kohler Schmid Möbus
(86) International application number: PCT/JP2004/018528
(87) International publication number: WO 2005/057986

(57) **Abstract**

There is provided a planar light emitter which is easy to manufacture and is capable of preventing degradation of a light-emitting layer which would otherwise occur over a long time period. The planar light emitter 4 is comprised of an organic EL laminate 1 in the form of a flat plate, and transparent intermediate films 3a and 3b filling spaces between the organic EL laminate 1 and two plate glasses 2a and 2b arranged in facing relation to each other to sandwich the organic EL laminate 1 such that they are each spaced therefrom by a predetermined distance. The intermediate films 3a and 3b are each larger in area than the organic EL laminate 1, and bonded to each other around the periphery of the organic EL laminate 1.

## Description

### Technical Field

The present invention relates to a planer light emitter and a method of manufacturing the same, and more particularly to a planer light emitter using an organic EL element.

### Background Art

Conventionally, as FPDs (Flat Panel Displays), there are known liquid crystal display panels using liquid crystal elements and EL display panels using EL elements. In particular, as EL display panels, ones using organic EL elements are considered to be promising.

The organic EL elements are classified into two types, specifically a passive type which is suitable for matrix display and an active type which is capable of performing high-speed switching of display by a high-speed switching function and hence suitable for moving picture display. For example, a passive-type organic EL element has a simple matrix structure, and is comprised of a substrate, transparent electrodes disposed on the substrate, an EL laminate formed of layers of organic substances formed on the upper surfaces of the transparent electrodes, including a light-emitting layer, back plates formed as a layer on the upper surface of the EL laminate, and a sealing plate bonded to the substrate having the EL laminate formed thereon.

Further, both the passive type and active type of the organic EL elements have their light-emitting layer selectively emit light by applying voltage selectively to transparent electrodes and the back plates opposed to each other with the EL laminate interposed therebetween, which thus makes it unnecessary to have light transmitted therethrough for display, differently from the liquid crystal element. Therefore, the use of organic EL element is not limited to display panels, but can be spread to planar light emitters as illumination sources.

However, the light-emitting layer of an organic EL element, which is formed of an organic substance as described above, is very vulnerable to moisture or like as environmental factors, and hence the moisture can degrade the light-emitting layer. The degradation of the light-emitting layer leads to occurrence of dark spots in the EL display panel.

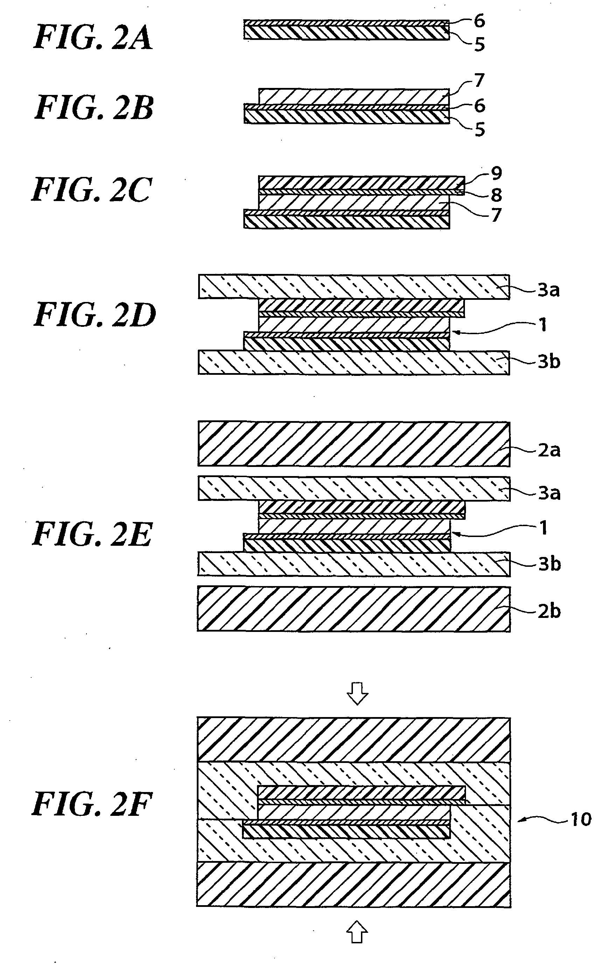

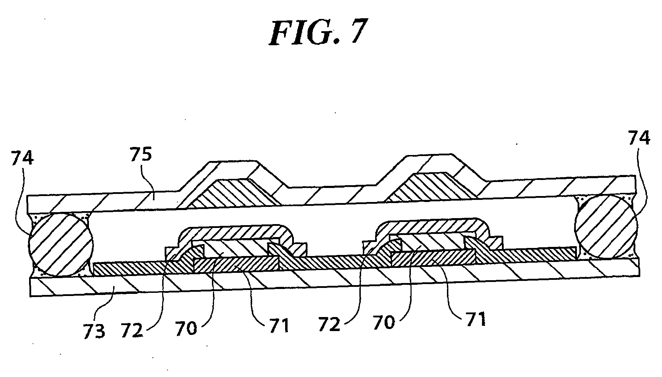

In view of this, to suppress occurrence of dark spots as shown in FIG. 7, there has conventionally been proposed an EL display panel comprising at least one organic layer 70 including a light-emitting layer, a laminate having the organic layer 70 sandwiched between transparent electrodes 71 and back plates 72, a glass substrate 73 on which the laminate is disposed, and a sealing plate 75 disposed on the glass substrate 73 via an adhesive 74 containing spacers, wherein the laminate is airtightly sealed (see e.g. Published Patent Application of Japan (Kokai) No. 2002-231442 (FIG. 2)).

In the case where a resin adhesive is used as a material of the adhesive 74 in the above-described EL display panel, the resin of the adhesive has moisture permeability depending on the type thereof, and hence there is a fear that moisture penetrates the EL element through the adhesive 74. To eliminate this inconvenience, there has recently been proposed an EL display panel in which a glass substrate and a sealing plate are bonded to each other using not an adhesive, but solder having no moisture permeability.

However, in the case where solder is used to bond the glass substrate and the sealing plate to each other, there are a lot of difficulties in the manufacturing of the EL display panel. For example, during the bonding process, it is required to hold the distance between the glass substrate and the sealing plate constant and to inject molten solder smoothly between the glass substrate and the sealing plate.

Further, in the above-described EL display panel, since there exists a space between the glass substrate and the sealing plate, even if the space is decompressed, a slight amount of moisture remains, and the moisture causes degradation of the light-emitting layer during a long time period.

The present invention has been made in view of these problems, and an object thereof is to provide a planar light emitter which is easy to manufacture and is capable of preventing degradation of a light-emitting layer which would otherwise occur over a long time period, and a method of manufacturing the planar light emitter.

### Disclosure of Invention

To attain the above object, in a first aspect of the present invention, there is provided a planar light emitter comprising a planar light-emitting part formed using an organic material, and a cover part covering both surfaces and a periphery of the light-emitting part.

In the present aspect, it is preferred that the cover part is formed of a thermoplastic resin.

In the present aspect, it is preferred that a transparent substrate covers the cover part.

In the present aspect, it is preferred that the light-emitting part includes an electrode and a conductor connected to the electrode, and the cover part covers the conductor over a predetermined length.

To attain the above object, in a second aspect of the present invention, there is provided a method of manufacturing a planar light emitter, comprising covering both surfaces and a periphery of a planar light-emitting part formed using an organic material, with a coating material.

In the present aspect, it is preferred that two film-like members which are formed of the coating material and are larger in area than the light-emitting part are aligned with each other with the light-emitting part interposed therebetween, and the aligned film-like members are bonded to each other at portions thereof where the light-emitting part is not interposed.

In the present aspect, it is preferred that the two film-like members are aligned with each other with other film-like members interposed between the portions thereof where the light-emitting part is not interposed.

### Brief Description of Drawings

FIG. 1 is a schematic cross-sectional view showing the construction of an EL display panel using a planar light emitter according to a first embodiment of the present invention;
FIGS. 2A to 2F are a manufacturing step chart of a method of manufacturing the EL display panel shown in FIG. 1;
FIG. 3A is a cross-sectional view of a usual planar light emitter, and FIG. 3B is a plan view of the planar light emitter shown in FIG. 3A;
FIG. 4A is a schematic cross-sectional view showing the construction of an EL display panel using a planar light emitter according to a second embodiment of the present invention, and FIG. 4B is a plan view of the EL display panel;
FIGS. 5A and 5B are views of variations of the planar light emitter according to the present embodiment;
FIGS. 6A to 6C are a manufacturing step chart of a method of manufacturing an EL display panel according to another embodiment of the present invention; and
FIG. 7 is a schematic cross-sectional view showing the construction of a conventional EL display panel.

### Best Mode for Carrying Out the Invention

The present invention will now be described in detail with reference to the drawings showing preferred embodiments thereof.

First, a description will be given of an EL display panel using a planar light emitter according to a first embodiment of the present invention with reference to the drawings.

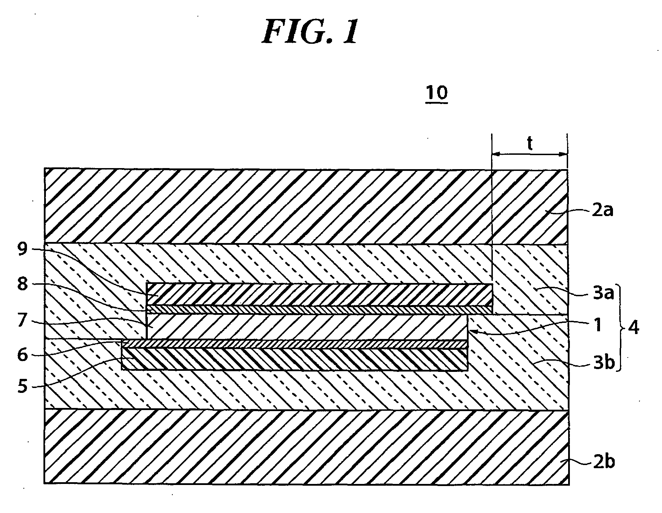

FIG. 1 is a schematic cross-sectional view showing the construction of the EL display panel using the planar light emitter according to the present embodiment.

As shown in FIG. 1, the EL display panel 10 is comprised of an organic EL laminate 1 in the form of a flat plate, two plate glasses 2a and 2b which are implemented by two non-alkaline glass substrates and are arranged in facing relation to each other to sandwich the organic EL laminate 1 such that they are each spaced therefrom by a predetermined distance, and transparent intermediate films 3a and 3b which are formed e.g. of EVA (ethylene-vinyl acetate copolymer) and fill spaces between the organic EL laminate 1 and the plate glasses 2a and 2b. In the EL display panel 10, the plate glasses 2a and 2b only function as members for defining the shape of the EL display panel 10, and hence the component elements of the planar light emitter 4 are the organic EL laminate 1 and the intermediate films 3a and 3b.

The organic EL laminate 1 is comprised of a lower polyethylene terephthalate film (hereinafter referred to as "PET film") 5 as a substrate, a lower transparent conductive film 6 formed by an indium-tin oxide film (hereinafter referred to as "ITO film") having a thickness of 300 nm and formed as a layer on a surface of the lower PET film 5, an organic EL laminate film 7 formed as layers including a light-emitting layer, described hereinafter, on an upper surface of the lower transparent conductive film 6, an upper transparent conductive film 8 implemented by an ITO film having a thickness of 500 nm and formed as a layer on an upper surface of the organic EL laminate film 7, and an upper PET film 9 covering the upper transparent conductive film 8 in a manner protecting the same.

The organic EL laminate film 7 is comprised of a 70 nm-thick hole transport layer formed of triphenylenediamine and disposed on the side of the lower transparent conductive film 6, a 70 nm-thick light-emitting layer formed by a quinolinol-aluminum complex and formed on an upper surface of the hole transport layer. Further, a transparent electron transport layer formed of triazole or oxiadiazole may be provided between the upper transparent conductive film 8 and the light-emitting layer.

In the EL display panel 10, the intermediate films 3a and 3b are both larger in area than the organic EL laminate 1, and bonded to each other at portions thereof where the organic EL laminate 1 is not interposed, so that the intermediate films 3a and 3b cover not only the both surfaces of the organic EL laminate 1 but also the periphery of the same. Preferably, a projection margin (t) of each of the intermediate films 3a and 3b, which projects outward from the periphery of the organic EL laminate 1, has a length of at least 1 mm in a horizontal direction, as viewed in the figure.

The EVA comprising the intermediate films 3a and 3b is a thermoplastic resin, and hence the intermediate films 3a and 3b are bonded to each other by being thermally melted. Therefore, no space is created between the periphery of the organic EL laminate 1 and the intermediate films 3a and 3b. Further, since the intermediate films 3a and 3b fill the space between the organic EL laminate 1 and the plate glasses 2a and 2b, no space is created, either, between the both surfaces of the organic EL laminate 1 and the plate glasses 2a and 2b.

Further, the plate glasses 2a and 2b formed of non-alkaline glass are moisture-impermeable, and the lower and upper transparent conductive films 6 and 8 each formed by an ITO film are also moisture-impermeable. Therefore, these prevent moisture from penetrating the organic EL laminate 1 from the both surfaces thereof. Furthermore, since the intermediate films 3a and 3b cover the periphery of the organic EL laminate 1 as described above, penetration of moisture from the periphery of the organic EL laminate 1 is also prevented.

Next, a method of manufacturing the EL display panel 10 will be described with reference to drawings.

FIGS. 2A to 2F are a manufacturing step chart of the method of manufacturing the EL display panel 10 shown in FIG. 1.

First, as shown in FIG. 2A, the lower transparent conductive film 6 is formed by the ion plating (IP) process on one surface of the lower PET film 5 cut out to a predetermined size, and then the hole transport layer and the light-emitting layer, and the electron transport layer, if necessary, are sequentially formed as layers on the upper surface of the formed lower transparent conductive film 6 in the mentioned order from below, as viewed in the figure, whereby the organic EL laminate film 7 is formed (FIG. 2B).

Further, the upper transparent conductive film 8 is formed by the IP process on one surface of the upper PET film 9 cut out to the same size as that of the lower PET film 5, and the upper PET film 9 is placed on the organic EL laminate film 7 such that the formed upper transparent conductive film 8 and the organic EL laminate film 7 face each other (FIG. 2C). Thereafter, the lower PET film 5, the lower transparent conductive film 6, the organic EL laminate film 7, the upper transparent conductive film 8, and the upper PET film 9 are press-bonded to each other by a roller or the like, whereby the organic EL laminate 1 is formed.

Then, the two intermediate films 3a and 3b larger in area than the organic EL laminate 1 are cut out from an EVA sheet having the predetermined thickness, and the intermediate film 3b, the organic EL laminate 1, and the intermediate film 3a are sequentially placed in layers in the mentioned order from below, as viewed in the figure, such that the cut-out intermediate films 3a and 3b face the respective surfaces of the organic EL laminate 1 (FIG. 2D). At this time, the intermediate films 3a and 3b are placed as layers such that the entire periphery of each of the intermediate films 3a and 3b projects outward from the periphery of the organic EL laminate 1.

Further, the two plate glasses 2a and 2b each having approximately the same area as that of the intermediate films 3a or 3b are cut out from a transparent non-alkaline plate glass having a thickness of 1.0 mm, and the plate glass 2b, the intermediate film 3b, the organic EL laminate 1, the intermediate film 3a, and the plate glass 2a are sequentially placed in layers in the mentioned order from below, as viewed in the figure, such that the cut-out plate glasses 2a and 2b face the respective surfaces of the organic EL laminate 1 via the respective intermediate films 3a and 3b, respectively (FIG. 2E).

Then, a pressing force is applied vertically, as viewed in the figure, while heating the organic EL laminate 1, the plate glasses 2a and 2b, and the intermediate films 3a and 3b disposed in layers as described above, whereby these are press-bonded to each other to form the EL display panel 10. In this process, the intermediate films 3a and 3b are thermally melted into a sol form, and squeezed by the pressing force between the organic EL laminate 1 and the plate glasses 2a and 2b to have its original thickness reduced. At this time, spilled EVA flows in around the periphery of the organic EL laminate 1. The spilled EVA continuously flows until a spilled EVA portion from the intermediate film 3a and a spilled EVA portion from the intermediate film 3b stick firmly to each other without any gap therebetween. Then, when the EL display panel 10 is cooled, the intermediate film 3a and the intermediate film 3b are bonded to each other and solidified around the periphery of the organic EL laminate 1 (FIG. 2F).

According to the planar light emitter 4 of the present embodiment, since the planar light emitter 4 includes the intermediate films 3a and 3b for covering both surfaces and periphery of the organic EL laminate 1, the organic EL laminate 1 is only required to be covered with the intermediate films 3a and 3b in the manufacturing of the EL display panel 10, which facilitates manufacturing of the EL display panel 10. Further, since the intermediate films 3a and 3b prevent space from being created on the both surfaces and periphery of the organic EL laminate 1, the EL display panel 10 contains no space touching the organic EL laminate film 7, which makes it possible to prevent degradation of the organic EL laminate film 7 which would otherwise occur over a long time period.

Further, since the intermediate films 3a and 3b are formed of EVA, which is a thermoplastic resin, it is possible to melt the intermediate films 3a and 3b simply by heating, thereby easily causing the molten EVA to flow in around the periphery of the organic EL laminate 1. This further facilitates manufacturing of the EL display panel 10, and at the same time makes it possible to positively cover the both surfaces and periphery of the organic EL laminate 1, thereby positively preventing degradation of the organic EL laminate film 7 which would otherwise occur over a long time period.

Furthermore, the intermediate films 3a and 3b are bonded to each other at portions thereof where the organic EL laminate 1 is not interposed, which also makes it possible to positively cover the periphery of the organic EL laminate 1.

Moreover, in the EL display panel 10, since the plate glasses 2a and 2b cover the respective intermediate films 3a and 3b, it is possible to positively block penetration of moisture into the organic EL laminate 1 from the upper and lower surfaces thereof through the intermediate films 3a and 3b.

Next, an EL display panel using a planar light emitter according to a second embodiment of the present invention will be described with reference to drawings.

The present embodiment has basically the same construction and effects as those of the above-described first embodiment. Therefore, the following description will be given only of different points of the construction and effects of the present embodiment from the first embodiment, while omitting duplicate description thereof.

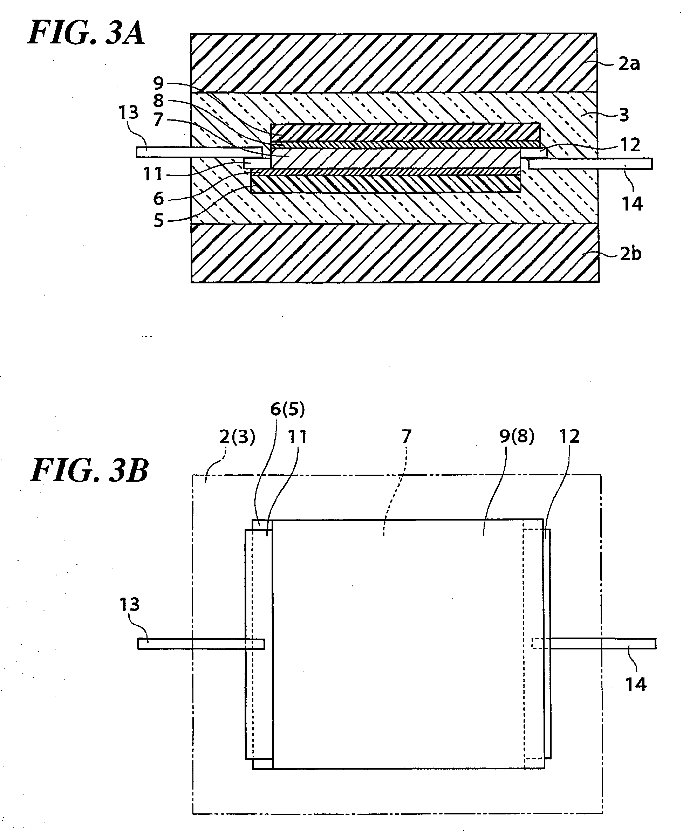

Usually, in the organic EL laminate 1 of the planar light emitter, the area of each of the lower PET film 5 and the upper PET film 9 is set to be larger than that of the organic EL laminate film 7, as shown in FIG. 3A, and hence the lower PET film 5 and the upper PET film 9 partially project outward from the periphery of the organic EL laminate film 7. Therefore, the lower transparent conductive film 6 and the upper transparent conductive film 8 formed on the surface of the lower PET film 5 and that of the upper PET film 9, respectively, are partially exposed from the organic EL laminate film 7. Electrode films 11 and 12 each formed e.g. by a copper thin film are connected to the exposed portions of the respective upper and lower transparent conductive films 6 and 8, and conductors 13 and 14 for applying voltage or conducting electric current from an external power supply (not shown) are connected to the respective electrode films 11 and 12.

From the viewpoint of prevention of voltage loss and current loss, it is preferred that each of the conductors 13 and 14 in the planar light emitter has a short wiring length, and hence the conductors 13 and 14 are conventionally led out over a shortest distance from the respective electrode films 11 and 12.

However, the conductors normally have a cylindrical shape, and its diameter is extremely small, so that the curvature of the cross section of the conductors 13 and 14 is large, so that it is difficult to cover the peripheral surfaces of the conductors 13 and 14 by the intermediate films 3a and 3b, which tends to cause creation of minute gaps in boundaries between the conductors 13 and 14 and the intermediate films 3a and 3b. If such minute gaps are created, moisture can penetrate the planar light emitter through the boundaries, and finally cause degradation of the organic EL laminate film 7.

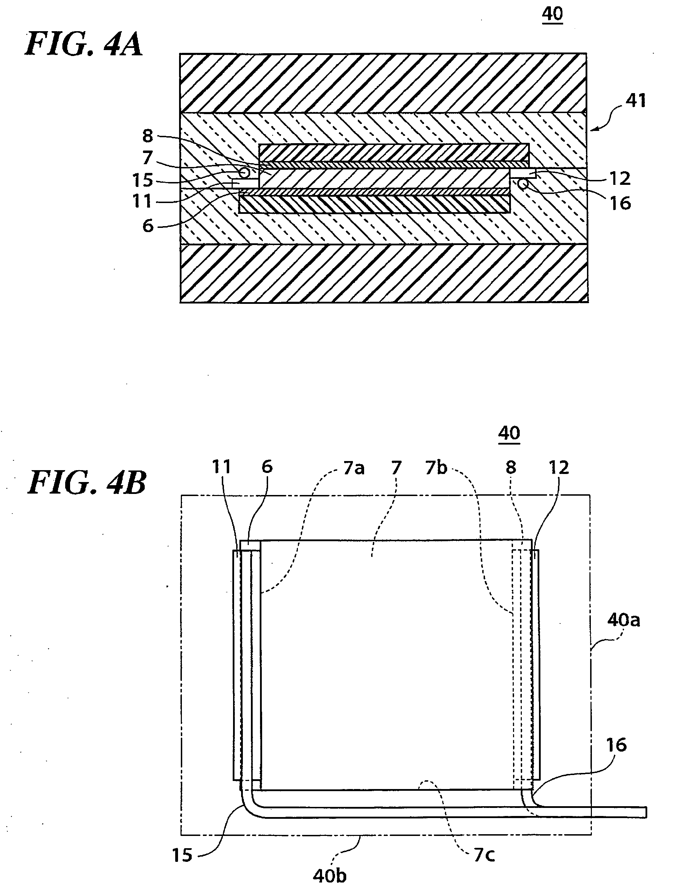

FIG. 4A is a schematic cross-sectional view showing the construction of the EL display panel using the planar light emitter according to the second embodiment of the invention, and FIG. 4B is a plan view of the EL display panel.

As shown in FIGS. 4A and 4B, in the planar light emitter 41 of the EL display panel 40, the lower transparent conductive film 6 has a portion exposed from a first side 7a of the organic EL laminate film 7, and the electrode film 11 is connected to the exposed portion of the lower transparent conductive film 6. Similarly, the upper transparent conductive film 8 has a portion exposed from a second side 7b of the organic EL laminate film 7 opposite to the first side 7a, and the electrode film 12 is connected to the exposed portion of the upper transparent conductive film 8.

A conductor 15 is connected to the electrode film 11. The conductor 15 is led out of the EL display panel 40 not over a shortest distance from the electrode film 11, but over a predetermined distance through the intermediate films 3a and 3b. More specifically, the conductor 15 is extended from the electrode film 11 to a location outward of a third side 7c of the organic EL laminate film 7 between the first side 7a and the second side 7b and passed along the third side 7c to be led out from a first side 40a of the EL display panel 40 opposed to the second side 7b of the organic EL laminate film 7 as it extends.

Further, a conductor 16 is connected to the electrode film 12. The conductor 16 is led out of the EL display panel 40 not over a shortest distance from the electrode film 12, either. More specifically, the conductor 16 is extended from the electrode film 12 toward a second side 40b of the EL display panel 40 in parallel relation to the third side 7c of the organic EL laminate film 7, and bent in the vicinity of the conductor 15 toward the first side 40a of the EL display panel 40 to be led out from the first side 40a as it extends.

The conductors 15 and 16, neither of which are led out over a shortest distance, are covered with the respective intermediate films 3a and 3b over the respective predetermined lengths.

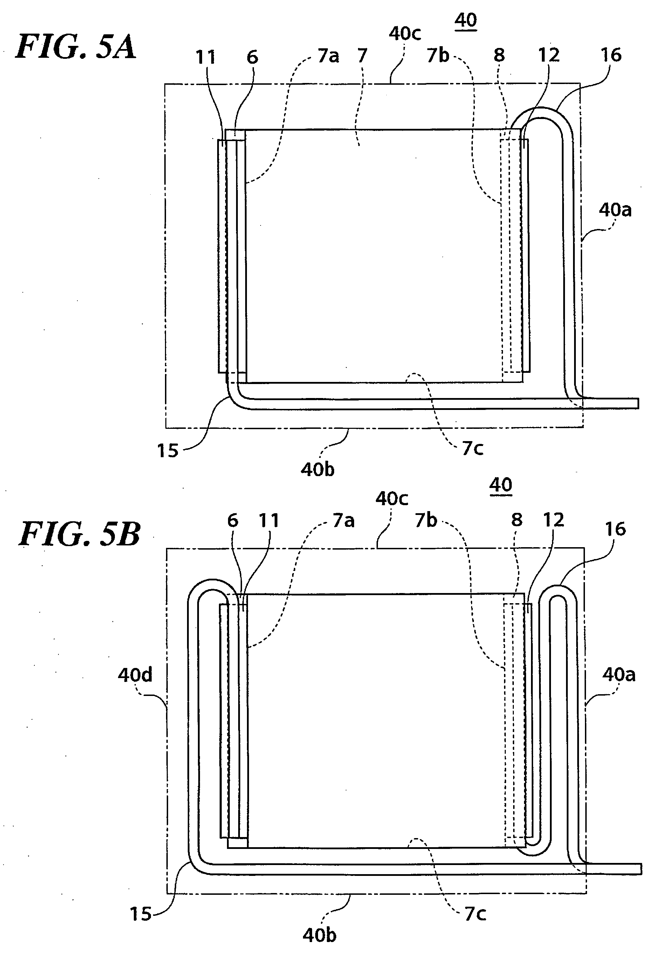

In the above case, it is preferred that the conductors 15 and 16 are routed through the respective intermediate films 3a and 3b over a longest possible distance to be led out of the EL display panel 40. For example, as shown in FIGS. 5A and 5B, the conductor 16 may be extended from the electrode film 12 toward a third side 40c of the EL display panel 40 opposite to the second side 40b, bent in the vicinity of the third side 40c toward the second side 40b, and then bent in the vicinity of the conductor 15 toward the first side 40a of the EL display panel 40 to be led out from the first side 40a (FIG. 5A) as it extends. Alternatively, the conductor 15 may be extended from the electrode film 11 toward the third side 40c of the EL display panel 40, bent in the vicinity of the third side 40c toward the second side 40b, extended to a location outward of the third side 7c of the organic EL laminate film 7, and then passed along the third side 7c to be led out from the first side 40a as it extends, while the conductor 16 may be extended from the electrode film 12 toward the second side 40b, bent toward the third side 40c, passed and returned along the first side 40a, and thereafter bent in the vicinity of the conductor 15 toward the first side 40a to be led out from the first side 40a (FIG. 5B) as it extends.

Usually, when the EL display panel 40 is installed, the first side 40a and a fourth side 40d opposite to the first side 40a are fitted in a sash or the like, and therefore from the viewpoint of the art of design, it is preferred that the conductors 15 and 16 are passed and returned along the first side 40a and the fourth side 40d.

A method of manufacturing the EL display panel 40 according to the present embodiment is the same as the above-described method of manufacturing the EL display panel 10, and hence description thereof is omitted.

According to the planar light emitter 41 of the present embodiment, since the intermediate films 3a and 3b cover the respective conductors 15 and 16 over the respective predetermined lengths, it is possible to prevent penetration of moisture through the boundaries between the conductors 15 and 16 and the intermediate films 3a and 3b, thereby more positively preventing degradation of the organic EL laminate film 7, which would otherwise occur over a long time period.

Although in the above-described first and second embodiments, the sol-state EVA obtained by thermally melting the intermediate films 3a and 3b is squeezed in the manufacturing of the EL display panel, thereby causing spilled EVA to flow in around the periphery of the organic EL laminate 1, other intermediate films may be provided in advance around the periphery of the organic EL laminate 1.

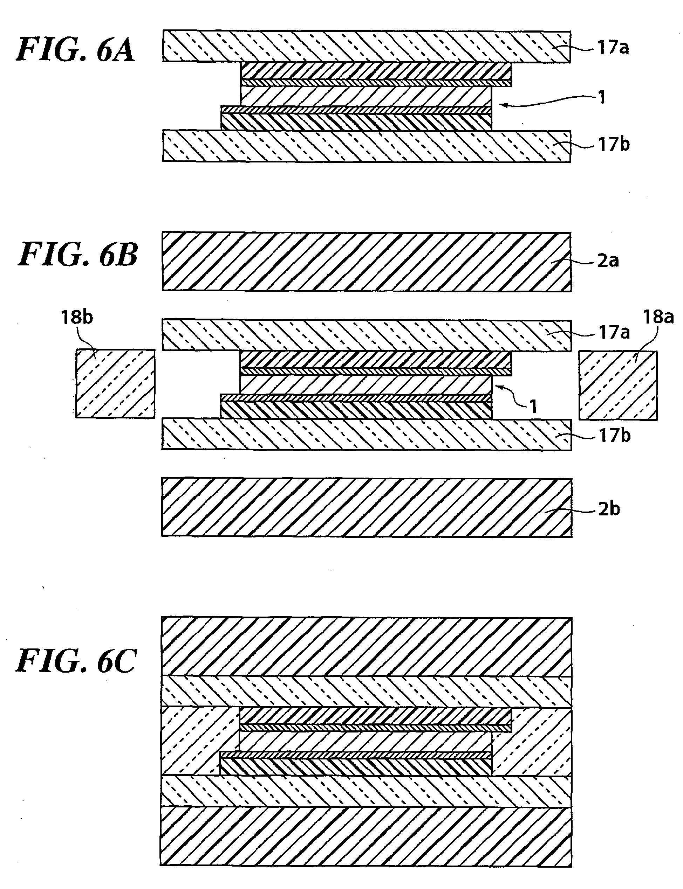

More specifically, as shown in FIGS. 6A to 6C, after the organic EL laminate 1 is formed, two intermediate films 17a and 17b larger in area than the organic EL laminate 1 are cut out from an EVA sheet, and the intermediate film 17b, the organic EL laminate 1, and the intermediate film 17a are sequentially placed in layers in the mentioned order from below, as viewed in the figure (FIG. 6A), whereafter two other intermediate films 18a and 18b cut out from an EVA sheet having approximately the same thickness as that of the organic EL laminate 1 are disposed on both peripheral sides of the organic EL laminate 1. Then, the intermediate film 17b, the organic EL laminate 1, and the intermediate film 17a placed in layers, and the intermediate films 18a and 18b are sandwiched by the two plate glasses 2a and 2b in a vertical direction, as viewed in the figure (FIG. 6B).

Then, the organic EL laminate 1, the intermediate films 17a and 17b, and the other intermediate films 18a and 18b sandwiched by the plate glasses 2a and 2b are heated and cooled, whereby the intermediate films 17a and 17b and the other intermediate films 18a and 18b are melted and solidified to be bonded to each other (FIG. 6C).

This makes it possible to positively prevent creation of gaps around the periphery of the organic EL laminate 1, whereby it is made possible to prevent more positively degradation of the organic EL laminate 1 which would otherwise occur over a long time period.

Although the planar light emitters according to the above-described first and second embodiments have their both surfaces covered by the plate glasses 2a and 2b, since the plate glasses 2a and 2b only function as members for defining the shape of the EL display panel, as described above, it is not necessarily required that the both surfaces of the planar light emitter are covered with the plate glasses 2a and 2b when the planar light emitter is actually used. In this case as well, since the both surfaces and periphery of the organic EL laminate 1 are covered with the intermediate films 3a and 3b, it is possible to provide the same advantageous effects as those described hereinabove.

Although in the planar light emitters according to the above-described first and second embodiments, a thermoplastic resin, such as EVA, is used as the material of the intermediate films 3a and 3b, a thermosetting resin may be used in place of the thermoplastic resin.

Further, the transparent substrates for covering the planar light emitters according the above-described first and second embodiments are not limited to the plate glasses 2a and 2b formed of a non-alkaline glass, but a low alkali glass, a soda lime glass subjected to processing for preventing alkaline elution, or a quartz glass can also be used. Further, the material of the substrate is not limited to a glass material, but a resin material or a metal material may be used. As the resin material, it is preferable to use an ABS (Acrylonitrile Butadiene Styrene) resin or an acrylic resin, and as the metal material, it is preferable to use A1, Cu, or Fe. Further, SUS, ceramics, Pt, or Au may be used. In the case where a metal material is used, however, the substrate is disposed in a manner opposed only to a surface of the organic EL laminate 1 opposite from the light-emitting surface of the same.

Although in the first and second embodiments, the organic EL laminate film 7 has a passive structure, it may have an active structure. Further, although in the first and second embodiments, the organic EL laminate 1 has a top emission structure, it may have a bottom emission structure.

Further, the EL laminate film may be an inorganic EL laminate film in place of the organic EL laminate film 7. In this case, there is employed an EL laminate film comprised of an insulating layer, a light-emitting layer, and another insulating layer, sequentially formed in layers in the mentioned order from the lower transparent conductive film 6, or an EL laminate film comprised of an electron barrier layer, a light-emitting layer, and a current-limiting layer sequentially formed in layers in the mentioned order from the lower transparent conductive film 6.

The construction of the present invention can be applied not only to the EL display panel 10, but also to a CRT, a PDP (Plasma Display Panel), and a liquid crystal display panel, and a structure corresponding to the construction of each type is provided between the lower transparent conductive film 6 and the upper transparent conductive film 8.

### Industrial Applicability

According to the planer light emitter of the present invention, the planar light emitter includes a planar light-emitting part formed using an organic material and a cover part covering both surfaces and a periphery of the light-emitting part, and therefore, it is only required to cover the light-emitting part by the cover part in manufacturing the planar light emitter, which facilitates manufacturing of the planar light emitter. Further, the planar light emitter contains no space touching the light-emitting part, which makes it possible to prevent degradation of the light-emitting part which would otherwise occur over a long time period.

According to the planar light emitter of the present invention, it is preferred that the cover part is formed of a thermoplastic resin. This makes it possible to easily and positively cover the both surfaces and periphery of the light-emitting part by melting and solidifying the thermoplastic resin, thereby not only further facilitating manufacturing of the planar light emitter, but also positively preventing degradation of the light-emitting part which would otherwise occur over a long time period.

According to the planar light emitter of the present invention, it is preferred that transparent substrates cover the cover part. This makes it possible to positively block penetration of moisture into the light-emitting part through the cover part, thereby more positively preventing degradation of the light-emitting part which would otherwise occur over a long time period.

According to the planar light emitter of the present invention, since the light-emitting part has an electrode and a conductor connected to the electrode, and the cover part covers the conductor over a predetermined length, it is possible to prevent penetration of moisture through a boundary between the conductor and the cover part, thereby further more positively preventing degradation of the light-emitting part which would otherwise occur over a long time period.

According to the planar light emitter-manufacturing method of the present invention, since both surfaces and a periphery of a light-emitting part formed using an organic material are covered with a coating material, it is possible to facilitate manufacturing of the planar light emitter. Further, since the planar light emitter contains no space touching the light-emitting part, it is possible to prevent degradation of the light-emitting part which would otherwise occur over a long time period.

According to the planar light emitter-manufacturing method of the present invention, two film-like members which are formed of a coating material and are larger in area than the light-emitting part are aligned with each other with the light-emitting part interposed therebetween, and the aligned film-like members are bonded to each other at portions thereof where the light-emitting part is not interposed. This makes it possible to positively cover the periphery of the light-emitting part, and thereby makes it possible to positively prevent degradation of the light-emitting part which would otherwise occur over a long time period.

In the method of manufacturing a planar light emitter, according to the present invention, it is preferred that the two film-like members are aligned with each other with other film-like members interposed between the portions thereof where the light-emitting part is not interposed. This makes it possible to positively prevent creation of gaps around the periphery of the light-emitting part, thereby more positively preventing degradation of the light-emitting part which would otherwise occur over a long time period.

## Claims

1. A planar light emitter **characterized by** comprising:
a planar light-emitting part formed using an organic material; and
a cover part covering both surfaces and a periphery of said light-emitting part.

2. A planar light emitter as claimed in claim 1, **characterized in that** said cover part is formed of a thermoplastic resin.

3. A planar light emitter as claimed in claim 1, **characterized in that** a transparent substrate covers said cover part.

4. A planar light emitter as claimed in claim 1, **characterized in that** said light-emitting part includes an electrode and a conductor connected to said electrode, and said cover part covers said conductor over a predetermined length.

5. A method of manufacturing a planar light emitter **characterized by** comprising covering both surfaces and a periphery of a planar light-emitting part formed using an organic material, with a coating material.

6. A method of manufacturing a planar light emitter as claimed in claim 5, **characterized in that** two film-like members which are formed of the coating material and are larger in area than the light-emitting part are aligned with each other with the light-emitting part interposed therebetween, and the aligned film-like members are bonded to each other at portions thereof where the light-emitting part is not interposed.

7. A method of manufacturing a planar light emitter as claimed in claim 6, **characterized in that** the two film-like members are aligned with each other with other film-like members interposed between the portions thereof where the light-emitting part is not interposed.

## Amended claims

### Amended claims under Art. 19.1 PCT

1. (Amended) A planar light emitter **characterized by** comprising:
a planar light-emitting part formed using an organic material; and
a cover part covering both surfaces and a periphery of said light-emitting part in a manner preventing creation of space.

2. (Amended) A planar light emitter as claimed in claim 1, **characterized in that** said cover part is formed of EVA (ethylene-vinyl acetate copolymer).

3. A planar light emitter as claimed in claim 1, **characterized in that** a transparent substrate covers said cover part.

4. (Amended) A planar light emitter as claimed in claim 1, **characterized in that** said light-emitting part comprises an electrode, and a conductor connected to said electrode via an electrode film having a rectangular shape in plan view, said conductor extending from said electrode film in a longitudinal direction of said electrode film, and then extending in a direction orthogonal to the longitudinal direction, and that said cover part covers said conductor over a predetermined length.

5. (Amended) A method of manufacturing a planar light emitter **characterized by** comprising covering both surfaces and a periphery of a planar light-emitting part formed using an organic material, with a coating material in a manner preventing creation of space.

6. A method of manufacturing a planar light emitter as claimed in claim 5, **characterized in that** two film-like members which are formed of the coating material and are larger in area than the light-emitting part are aligned with each other with the light-emitting part interposed therebetween, and the aligned film-like members are bonded to each other at portions thereof where the light-emitting part is not interposed.

7. A method of manufacturing a planar light emitter as claimed in claim 6, **characterized in that** the two film-like members are aligned with each other with other film-like members interposed between the portions thereof where the light-emitting part is not interposed.

8. (Added) A planar light emitter as claimed in claim 1, **characterized in that** said light-emitting part comprises an electrode, and a conductor connected to said electrode via an electrode film having a rectangular shape in plan view, said conductor extending from said electrode film in a longitudinal direction of said electrode film, then returning along the longitudinal direction and further extending in a direction orthogonal to the longitudinal direction, and that said cover part covers said conductor over a predetermined length.
